# EUROPEAN PATENT APPLICATION

(11) **EP 4 607 314 A1**
(43) Date of publication of application: **27.08.2025**
(21) Application number: 24219231.8
(22) Date of filing: 11.12.2024
(51) Int. Cl.: G06F 1/16, E05D 11/08

(54) **HINGE DEVICE AND ELECTRONIC APPARATUS**

(30) Priority: 22.02.2024 JP 2024025602
(71) Applicant: Lenovo (Singapore) Pte. Ltd, New Tech Park 556741 (SG)
(72) Inventor: LIU, Yalu, Yokohama-shi 220-0012 (JP); TAKASHIMA, Akashi, Yokohama-shi 220-0012 (JP)
(74) Representative: Openshaw & Co.

(57) **Abstract**

Provided is a hinge device capable of generating sufficient torque while having a small diameter and suppressing vibration between chassis. The hinge device includes a shaft that is pivotally supported by a bearing portion and is rotatable, a first torque application unit configured to apply a frictional force to a peripheral surface of the shaft by fitting the shaft to the first torque application unit, and a second torque application unit configured to apply a frictional force to the shaft in an axial direction. The second torque application unit includes a flange that is formed on the shaft and abuts onto one end of the bearing portion, and a nut that is screwed to a male screw portion of the shaft and is tightened to the other end of the bearing portion via washers and a disc.

## Description

### BACKGROUND OF THE INVENTION

### Field of the Invention

The present invention relates to a hinge device that connects a first chassis and a second chassis to be rotationally movable, and an electronic apparatus in which the first chassis and the second chassis are connected in a rotationally movable manner by the hinge device.

### Description of the Related Art

In an electronic apparatus such as a laptop PC, a configuration is used in which two chassis are connected to each other relatively in a rotationally movable manner by a hinge device. This type of electronic apparatus needs to be able to hold the chassis in a stable manner at a desired angular posture while ensuring a smooth rotational movement operation between the chassis. Therefore, the hinge device needs to be able to generate appropriate rotational torque. As a mechanism that generates the rotational torque, for example, there is a configuration in which a leaf spring is interposed between a bracket and a shaft to generate sliding resistance (see Japanese Unexamined Patent Application Publication No. 2019-190518).

### SUMMARY OF THE INVENTION

The configuration disclosed in Japanese Unexamined Patent Application Publication No. 2019-190518 is a biaxial type in which each of a first chassis and a second chassis has a shaft. In addition, this requires a larger diameter to generate sufficient rotational torque, which is not desirable for further thinning of the electronic apparatus.

In addition, as another torque generation mechanism, there is a mechanism in which one end of a bracket fixed to a chassis is curled and wound around a shaft of a hinge to generate sliding resistance. However, in this configuration, in order to generate sufficient rotational torque, it is necessary to provide the curled portion to be long in the axial direction and to make the straightness of the shaft portion corresponding thereto high, which makes manufacturing difficult. In addition, in this configuration, the curled portion is elastic, and vibration is likely to occur between the two chassis.

The present invention has been made in view of the above-described problems, and an object of the present invention is to provide a hinge device and an electronic apparatus that can generate a sufficient torque even with a small diameter and suppress vibration between chassis.

In order to achieve the object and solve the above-described problem, according to an embodiment of the present invention, there is provided a hinge device that connects a first chassis and a second chassis to each other in a rotationally movable manner, the hinge device including a shaft that is pivotally supported by a bearing portion and is rotatable, a first torque application unit configured to apply a frictional force to a peripheral surface of the shaft by fitting the shaft to the first torque application unit, and a second torque application unit configured to apply a frictional force to the shaft in an axial direction.

In addition, an electronic apparatus according to the embodiment of the present invention is an electronic apparatus in which a first chassis and a second chassis are connected to each other in a rotationally movable manner by a hinge device, in which the hinge device includes a shaft that is pivotally supported by and rotatable about a bearing portion, a first torque application unit configured to apply a frictional force to a peripheral surface of the shaft by fitting the shaft to the first torque application unit, and a second torque application unit configured to apply a frictional force to the shaft in an axial direction.

According to the above-described aspect of the present invention, since the shafts are shared by the first torque application unit and the second torque application unit to apply rotational torque, sufficient torque can be generated. In addition, the first torque application unit does not need to have a large diameter because the first torque application unit covers the peripheral surface, and the second torque application unit does not need to be large in the radial direction according to the amount of torque to be shared, and a small diameter is sufficient, resulting in a hinge device having a smaller diameter. The second torque application unit hardly expands and contracts in the circumferential direction, and vibration is unlikely to occur between the chassis.

### BRIEF DESCRIPTION OF THE DRAWINGS

FIG. 1 is a schematic plan view of an electronic apparatus including a hinge device according to an embodiment of the present invention as viewed from above.
FIG. 2 is a perspective view of the hinge device and a peripheral portion thereof.
FIG. 3 is an exploded perspective view of the hinge device.

### DETAILED DESCRIPTION OF THE INVENTION

Hereinafter, an embodiment of a hinge device according to the present invention will be described in detail with reference to drawings. The present invention is not limited to this embodiment.

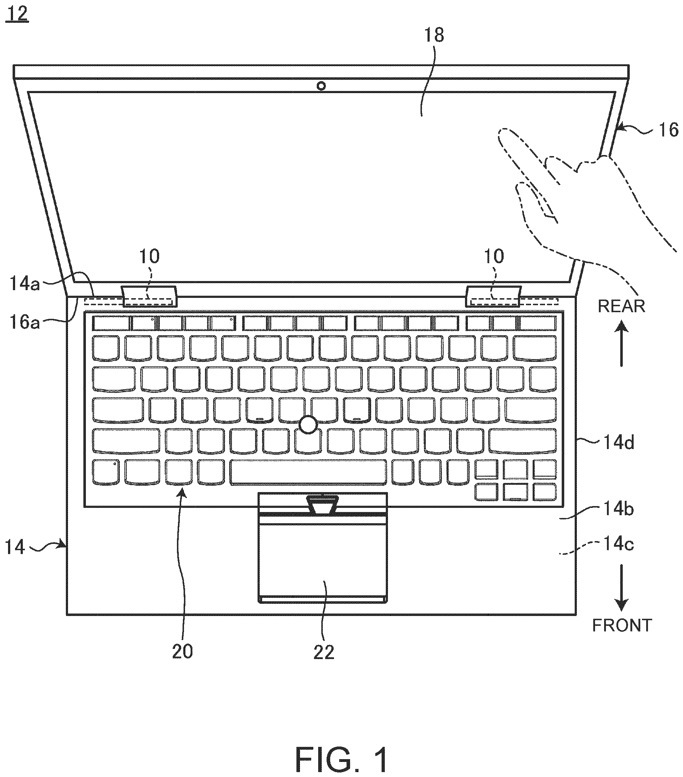

FIG. 1 is a schematic plan view of an electronic apparatus 12 including a hinge device 10 according to an embodiment of the present invention as viewed from above. As illustrated in FIG. 1, the electronic apparatus 12 is a clamshell-type laptop PC in which a first chassis 14 and a second chassis 16 are connected to each other relatively in a rotationally movable manner by the hinge device 10. The electronic apparatus according to the present invention may be a portable phone, a smartphone, a portable game machine, or the like, in addition to a laptop PC.

First, an overall configuration of the electronic apparatus 12 will be described. The electronic apparatus 12 has a rear end portion 14a of the first chassis 14 and a lower end portion 16a of the second chassis 16 connected by a pair of left and right hinge devices 10 and 10 so as to be opened and closed. The hinge device 10 may be installed in one or three or more pairs instead of a pair of left and right sides.

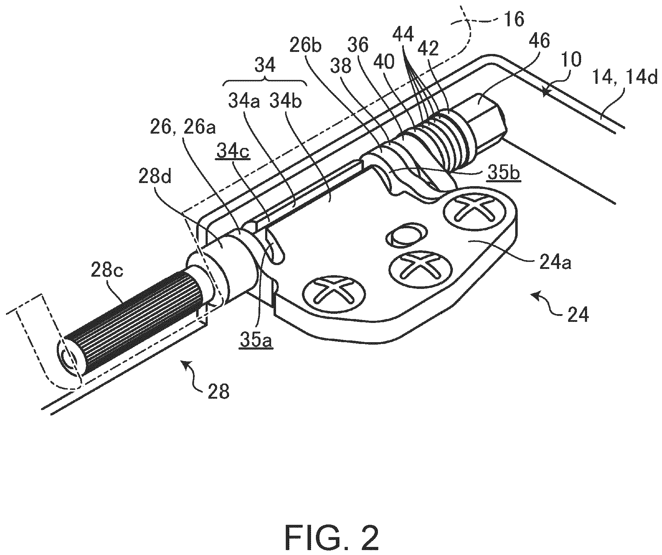

The first chassis 14 is a flat box formed of an upper cover material 14b and a lower cover material 14c. The first chassis 14 has an upper surface formed of the upper cover material 14b and a lower surface formed of the lower cover material 14c. The four peripheral side surfaces of the first chassis 14 are formed by a standing wall 14d provided on one of the cover materials 14b and 14c (see FIG. 2 and the like). A keyboard 20 and a touch pad 22 are provided on an upper surface of the first chassis 14. Various electronic components such as a motherboard, a computing device, a memory, and a battery device are housed inside the first chassis 14.

The second chassis 16 is a flat box that is formed to be thinner than the first chassis 14. A display 18 is provided on a front surface of the second chassis 16. The display 18 is, for example, a liquid crystal display or an organic light emitting diode (OLED) display. The display 18 is a touch panel type and can be operated by a hand or a pen as indicated by a virtual line.

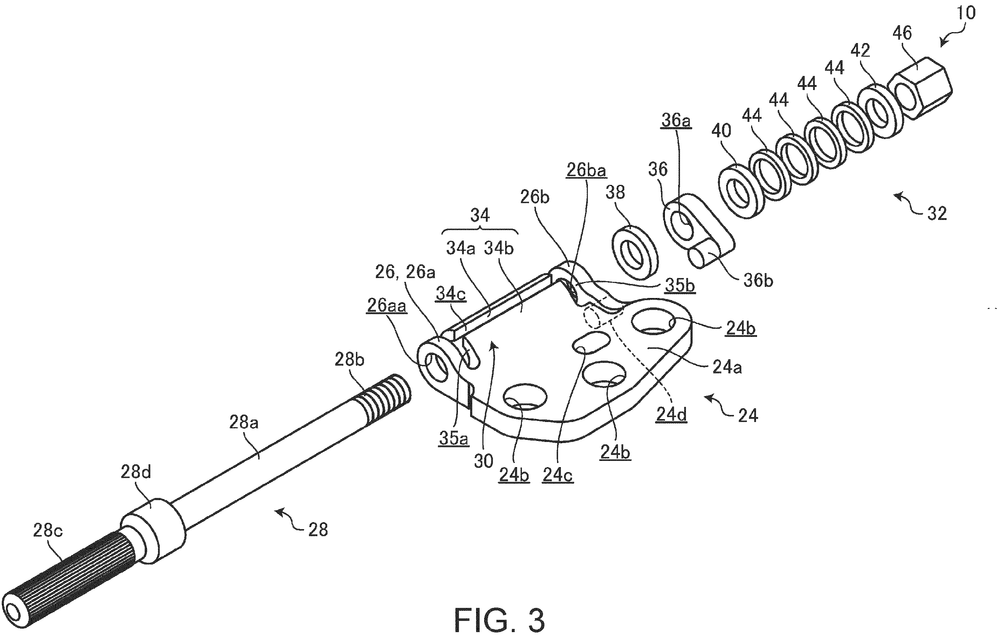

Next, a specific configuration example of the hinge device 10 will be described. FIG. 2 is a perspective view of the hinge device 10 and a peripheral portion thereof. FIG. 3 is an exploded perspective view of the hinge device 10. Since the left and right hinge devices 10 have the same configuration except that the left and right hinge devices 10 are bilaterally symmetric, one hinge device 10 will be described below, and the other hinge device 10 will not be described. The left-right orientation of the hinge device 10 will be described with reference to FIGS. 2 and 3.

As illustrated in FIGS. 2 and 3, the hinge device 10 is based on a bracket 24 that is fixed to the first chassis 14, and a shaft 28 that is pivotally supported by and rotatable about a bearing portion 26 provided on the bracket 24 so as to be rotatable. The bracket 24 is fixed to the first chassis 14 by inserting screws into three screw holes 24b in a main body 24a, and is positioned by inserting a pin into a pin hole 24c. The main body 24a has an appropriate left-right width.

The bearing portion 26 is integrated with the bracket 24 and includes a first bearing portion 26a and a second bearing portion 26b formed to protrude rearward from both left and right ends of the main body 24a. That is, the first bearing portion 26a and the second bearing portion 26b are connected to each other via the main body 24a. The first bearing portion 26a and the second bearing portion 26b are appropriately spaced from each other so that the shaft 28 can be pivotally supported in a stable manner. The first bearing portion 26a is on the left side, and the second bearing portion 26b is on the right side.

The shaft 28 has a solid structure, and has a shaft portion 28a, a male screw portion 28b provided at a right end portion of the shaft portion 28a, a serration 28c provided on a left side, and a moderately thick flange 28d provided between the shaft portion 28a and the serration 28c. The shaft 28 is pivotally supported such that the shaft portion 28a passes through shaft support holes 26aa, 26ba formed in the first bearing portion 26a and the second bearing portion 26b. The serration 28c is coupled to a part of the second chassis 16. Depending on the load conditions and the like, the hinge device 10, and the first chassis 14 and the second chassis 16 may be connected by a bracket or a serration.

The hinge device 10 further includes a first torque application unit 30 and a second torque application unit 32. The first torque application unit 30 generates rotational torque by applying a frictional force to a peripheral surface of the shaft portion 28a by fitting the shaft portion 28a of the shaft 28. The second torque application unit 32 generates rotational torque by applying a frictional force to the shaft 28 in the axial direction.

The first torque application unit 30 is configured with a band 34. The band 34 is integrated with the bracket 24 and is provided behind the main body 24a. The first torque application unit 30 is disposed between the first bearing portion 26a and the second bearing portion 26b with narrow gaps 35a and 35b from the first bearing portion 26a and the second bearing portion 26b.

The band 34 has a cross-sectional C-shape, including a first arc portion 34a and a second arc portion 34b, and a slit 34c is formed between the first arc portion 34a and the second arc portion 34b. The first arc portion 34a has a larger arc angle than the second arc portion 34b. Since the slit 34c is provided, a difference in torque generated between the opening operation and the closing operation of the chassis 14 and 16 occurs, and the opening operation torque and the closing operation torque can be set to be different from each other. The band 34 is not limited to the C-shape and may have any shape as long as a frictional force can be applied to the shaft portion 28a to be fitted, and may be, for example, a columnar shape. The band 34 may be formed by bending a part of the bracket 24 in an arc shape, may be formed by die molding, or may be formed by CNC machining or the like.

The second torque application unit 32 includes a fitting member 36, a first washer 38, a second washer 40, a third washer 42, a plurality of discs (elastic members) 44, and a nut 46. The fitting member 36 has a so-called cam shape, has a portion protruding rearward from a main portion in which the shaft hole 36a is formed, and a protrusion 36b protrudes from an end portion thereof to the left side. The protrusion 36b is inserted into the hole 24d formed in the side surface of the bracket 24 to serve as a rotation stopper of the fitting member 36. The depth of the hole 24d is larger than the protrusion length of the protrusion 36b. The disc 44 is a leaf spring formed of a dish-shaped metal plate, and four leaf springs are laminated in the present example.

In the shaft 28, the shaft portion 28a protrudes to the right side through the first bearing portion 26a, the band 34, and the second bearing portion 26b. The flange 28d abuts onto an end surface of the first bearing portion 26a. The first washer 38, the fitting member 36, the second washer 40, the plurality of discs 44, and the third washer 42 are inserted into a portion of the shaft portion 28a, which protrudes from the second bearing portion 26b, without a gap in order from the left. The nut 46 is screwed to the male screw portion 28b at the right end portion, and the right end of the second bearing portion 26b is tightened with an appropriate force via the fitting member 36, the washers 38, 40, and 42, and the disc 44. The nut 46 may be subjected to a locking treatment.

The second torque application unit 32 generates a frictional force in the axial direction with respect to the shaft 28 by causing the disc 44 to be elastically compressed by generating an axial force on the shaft 28 by tightening the nut 46. Then, rotational torque is applied to the shaft 28 by frictional resistance on the sliding surface between the flange 28d and the first bearing portion 26a and on the sliding surfaces of the second bearing portion 26bb, the fitting member 36, the washers 38, 40, and 42, and the disc 44. In the present example, the frictional force is dispersed by providing a large number of sliding surfaces, which is suitable, but the number of sliding surfaces may be increased or decreased depending on the conditions. The number of the sliding surfaces can be increased or decreased, for example, by increasing or decreasing the number of the discs 44 or by presence or absence of the fitting member 36.

As described above, in the hinge device 10 and the electronic apparatus 12 according to the present embodiment, since the first torque application unit 30 and the second torque application unit 32 share the rotational torque to the shaft 28, the torque generated by each unit is only half, and when the torque is added together, sufficient torque can be generated. However, the torque sharing amounts between the first torque application unit 30 and the second torque application unit 32 are not limited to being equal, and may differ to some extent.

Since the band 34 covers the peripheral surface of the first torque application unit 30, the first torque application unit 30 does not need to have a large diameter. In addition, since only half of the torque is shared, there is no need to lengthen the shaft in the axial direction, and the straightness of the shaft 28 portion to be fitted can be achieved with relatively low precision, thereby making manufacturing easy.

The second torque application unit 32 does not need to be larger in the radial direction because only half of the torque is shared, and a smaller diameter is sufficient. In addition, the first torque application unit 30 can slightly expand and contract in the circumferential direction due to elasticity of the band 34, but the second torque application unit 32 hardly expands and contracts in the circumferential direction, and vibration is unlikely to occur between the first chassis 14 and the second chassis 16, and especially, in the touch panel type electronic apparatus 12, the display 18 is easy to operate by touch in a stable manner. Since the first torque application unit 30 and the second torque application unit 32 each have a small diameter, the hinge device 10 contributes to thinning of the first chassis 14 in which the shaft 28 is provided.

The bearing portion 26 includes the first bearing portion 26a and the second bearing portion 26b connected via the bracket 24, and since the first torque application unit 30 is provided between the first bearing portion 26a and the second bearing portion 26b, space efficiency is good. In addition, since the first torque application unit 30 is disposed with the gaps 35a and 35b between the first bearing portion 26a and the second bearing portion 26b, no axial force is applied to the band 34, and a frictional force can be appropriately applied to the peripheral surface of the shaft 28. The band 34 of the first torque application unit 30 is integrated with the bracket 24, and the configuration is simple. The hinge device 10 is a uniaxial type in which the shaft 28 is provided only in the first chassis 14, and thus, the occupied space is smaller than that of the biaxial type.

The present invention is not limited to the above-described embodiment, and there is no doubt that the present invention can be freely changed without departing from the gist of the present invention.

### Description of Symbols

- 10: hinge device
- 12: electronic apparatus
- 22: touch pad
- 24: bracket
- 24a: main body
- 26: bearing portion
- 26a: first bearing portion
- 26b: second bearing portion
- 28: shaft
- 28a: shaft portion
- 28b: male screw portion
- 28c: serration
- 28d: flange
- 30: first torque application unit
- 32: second torque application unit
- 34: band
- 35a, 35b: gap
- 36: cam
- 38, 40, 42: washer
- 44: disc
- 46: nut

## Claims

1. A hinge device configured to connect a first chassis and a second chassis to each other in a rotationally movable manner, the hinge device comprising:
a shaft that is pivotally supported by a bearing portion and is rotatable;
a first torque application unit configured to apply a frictional force to a peripheral surface of the shaft by fitting the shaft to the first torque application unit; and
a second torque application unit configured to apply a frictional force to the shaft in an axial direction.

2. The hinge device according to claim 1, wherein
the second torque application unit includes
a flange that is formed on the shaft and abuts onto one end of the bearing portion, and
a nut that is screwed to a screw portion of the shaft and is tightened to the other end of the bearing portion via an elastic member.

3. The hinge device according to claim 1 or claim 2, wherein
the bearing portion includes a first bearing portion and a second bearing portion connected via a bracket, and
the first torque application unit is disposed between the first bearing portion and the second bearing portion with a gap between the first bearing portion and the second bearing portion.

4. The hinge device according to claim 3, wherein the first torque application unit is integrated with the bracket.

5. An electronic apparatus comprising a first chassis, a second chassis, and a hinge device, in which the first chassis and the second chassis are connected to each other in a rotationally movable manner by the hinge device, wherein
the hinge device includes:
a shaft that is pivotally supported by and rotatable about a bearing portion;
a first torque application unit configured to apply a frictional force to a peripheral surface of the shaft by fitting the shaft to the first torque application unit; and
a second torque application unit configured to apply a frictional force to the shaft in an axial direction.

6. The electronic apparatus according to claim 5, wherein
the second torque application unit includes:
a flange that is formed on the shaft and abuts onto one end of the bearing portion; and
a nut that is screwed to a screw portion of the shaft and is tightened to the other end of the bearing portion via an elastic member.

7. The electronic apparatus according to claim 5 or claim 6, wherein:
the bearing portion includes a first bearing portion and a second bearing portion connected via a bracket; and
the first torque application unit is disposed between the first bearing portion and the second bearing portion with a gap between the first bearing portion and the second bearing portion.

8. The electronic apparatus according to claim 7, wherein
the first torque application unit is integrated with the bracket.
